# EUROPEAN PATENT SPECIFICATION

(11) **EP 3 692 771 B1**
(45) Date of publication and mention of the grant of the patent: **29.12.2021**
(21) Application number: 18778938.3
(22) Date of filing: 03.10.2018
(51) Int. Cl.: H05K 3/12, H05K 1/09, H05K 1/03

(54) **ROOM-TEMPERATURE PLASMA-ASSISTED INKJET-PRINTING OF A LIQUID MOD INK ON A POROUS SUBSTRATE**
PLASMAUNTERSTÜTZTES TINTENSTRAHLDRUCKEN EINER FLÜSSIGEN MOD-TINTE AUF EINEM PORÖSEN SUBSTRAT BEI RAUMTEMPERATUR
IMPRESSION À JET D'ENCRE ASSISTÉE PAR PLASMA À TEMPÉRATURE AMBIANTE D'UNE ENCRE MOD LIQUIDE SUR UN SUBSTRAT POREUX

(30) Priority: 03.10.2017 LU 100463
(43) Date of publication of application: 12.08.2020
(73) Proprietor: Luxembourg Institute of Science and Technology (LIST), 4362 Esch-sur-Alzette (LU); UCL Business PLC (UCLB), London W1T 4TP (GB)
(72) Inventor: BOSCHER, Nicolas, 57390 Audun le Tiche (FR); CHEMIN, Jean-Baptiste, 54190 Villerupt (FR); CHOQUET, Patrick, 57050 Longeville les Metz (FR); KNAPP, Caroline, London E4 9QQ (GB)
(74) Representative: Lecomte & Partners
(86) International application number: PCT/EP2018/076920
(87) International publication number: WO 2019/068770

(56) References cited:
- EP-A1- 2 207 407
- YOUSEF FARRAJ ET AL: "Plasma-Induced Decomposition of Copper Complex Ink for the Formation of Highly Conductive Copper Tracks on Heat-Sensitive Substrates", ACS APPLIED MATERIALS & INTERFACES, vol. 9, no. 10, 15 March 2017 (2017-03-15) , pages 8766-8773, XP055478544, US ISSN: 1944-8244, DOI: 10.1021/acsami.6b14462 cited in the application

## Description

### Technical field

The invention is directed to the field of surface modification of porous substrate, preferentially of heat-sensitive substrate.

### Background art

The formation of highly conductive features on heat-sensitive substrates, and more particularly on paper, is highly desirable, notably in the achievement of low cost flexible and paper-based electronic devices, including high frequency devices.

Farraj Y. *et al.* have studied the plasma-induced decomposition of copper complex ink for the formation of highly conductive copper tracks on heat sensitive substrates (ACS Applied Mat. Interfaces, 2017, 9 (10), 8766-8773). In this study, low pressure plasma (0.2 mbar) of argon or nitrogen was used to provide the decomposition of a copper complex into metallic copper without heating at high temperatures (more precisely, below 70°C). Metal-organic decomposition (MOD) copper ink was exposed to 160W plasma for 8 minutes on a plastic substrate. This has resulted in a highly conductive track of metal copper, showing a resistivity of 7.3 ± 0.2 µΩ cm.

The drawback of this study is that low pressure plasma is used, which may bring some inconvenience during the setup of the system for treating the surface. The temperature which has been used is about 70°C, which is not really suitable for real heat-sensitive substrate. Moreover, the 8 minutes plasma exposure is rather a long time of exposure, leading to absorption of the liquid ink into the porous substrate.

Prior art patent document published EP 2 207 407 A1 discloses a method for depositing a conductive metal layer on a porous substrate, according to the preamble of claim 1.

### Summary of invention

### Technical Problem

The invention has for technical problem to provide a simple efficient process which functionalizes a porous heat-sensitive flexible substrate with a highly electrically conductive metallic track, this functionalization being prevented from some penetration of metallic-based material inside the substrate itself.

### Technical solution

The invention is directed to a method for depositing a conductive metal layer on a porous substrate, said method comprising the steps of (a) providing at least one porous substrate, (b) inkjet-printing a liquid metal-organic decomposition ink on said at least one porous substrate, and (c) providing a plasma exposure, wherein step (c) is performed less than 10 seconds after the end of step (b).

According to a preferred embodiment, step (c) is performed less than 1 second after the end of step (b).

According to a preferred embodiment, step (c) is performed less than 800 µs after the end of step (b).

According to a preferred embodiment, said plasma exposure is performed at atmospheric pressure.

According to a preferred embodiment, said liquid metal-organic decomposition ink is a liquid metal-organic decomposition silver ink, a liquid metal-organic decomposition copper ink, a liquid metal-organic decomposition aluminium ink, a liquid metal-organic decomposition gold ink, a liquid metal-organic decomposition platinum ink, or a liquid metal-organic decomposition molybdenum ink.

According to a preferred embodiment, said porous substrate is a heat-sensitive substrate.

According to a preferred embodiment, said porous substrate comprises pores with a size comprised between 1 nm and 100 µm.

According to a preferred embodiment, said porous substrate is paper, cardboard, wood, textile, foam or one porous polymer, preferentially paper.

According to a preferred embodiment, said porous substrate is flexible.

According to a preferred embodiment, step (c) is performed during a time comprised between 1 second and 5 seconds, preferentially during a time of 2 seconds.

According to a preferred embodiment, the temperature is comprised between 20°C and 50°C, preferentially between 20°C and 27°C.

According to a preferred embodiment, said step (c) is performed by means of a dielectric barrier discharge or by means of a plasma torch.

According to a preferred embodiment, said plasma exposure is a plasma discharge with a power comprised between 1 W/cm² and 10 W/cm², preferentially of 2 W/cm².

According to a preferred embodiment, said plasma exposure is a plasma discharge comprising nitrogen, argon, helium and/or hydrogen.

According to a preferred embodiment, steps (b) and (c) are repeated at least 10 times.

### Advantages of the invention

The process of the present invention is particularly interesting in that it is carried out at room temperature (and is therefore very suitable for heat-sensitive substrate, such as paper or textile), at atmospheric pressure (which favours a simple way to make it work) and which overcomes any wetting issues often encountered on the porous substrate.

### Brief description of the drawings

Figure 1: Scheme of the process of the present invention.
Figure 2: Top-down high magnification microscope image of plasma-assisted inkjet-printed silver on paper.
Figure 3: Cross-sectional microscope image showing a 2 µm thick plasma-assisted inkjet-printed silver line on a paper substrate.
Figure 4: Front and back-side large area of plasma-assisted inkjet-printed silver line on a folded paper substrate.
Figure 5: Front and back-side large area of room temperature conversion of silver MOD ink during 24h on a folded paper substrate.
Figure 6: Indexed XRD pattern of plasma-assisted inkjet-printed silver on paper over the range of 30° < 2 θ < 80° (top plot), standard XRD patterns for bulk silver (middle plot) and paper substrate (below plot) are given for comparison.
Figure 7: XPS spectrum showing the Ag 3d transition on paper.
Figure 8: XPS spectrum showing the Ag MNN Auger transition on paper (middle plot), silver oxide formed from the decomposition of the ink on paper (top plot) and a comparison with a pure bulk reference metallic Ag (below plot).
Figure 9: XRD pattern for copper.
Figure 10: XPS spectrum showing the Cu 2p transition on paper.

### Description of an embodiment

The present invention concerns the atmospheric pressure and room temperature of metallic patterns on a heat sensitive substrate. An example of a paper substrate where a silver track has been deposited is demonstrated. Silver is highly conductive and stable to oxidation. Copper tracks can also be deposited, using the same process. Copper has an electrical conductivity which is only 6% lower than the one of silver but is about 100 times cheaper (in 2017). Other metals can also be deposited on the heat sensitive substrate. Although paper has been exemplified, other porous substrates can be used, such as cardboard, wood, textile, foam or porous polymers. The process of the present invention indeed avoids the penetration of the liquid metallic precursor into the pores of the substrate because of its features, especially the fact that the plasma exposure is conducted very quickly after a step of providing the liquid metallic precursor to the substrate. Due to the fact that the time of providing the plasma exposure is inferior to 10 seconds, and in most cases is typically inferior to 1 second, the liquid metallic precursor is quickly reduced and transformed in metal, and stays at the surface of the porous substrate, without penetrating into the substrate.

Moreover, the present invention proposes a process which is working very well at room temperature, namely between 20°C and 27°C. Therefore, there is no need to heat the porous substrate, which is a great advantage when heat-sensitive substrates, such as paper (a normal sheet of paper suitable for everyday use), are to be functionalized with a conductive track.

The size of the pore of the porous substrate is comprised between 1 nm and 100 µm. For example, the paper substrate has two pore size distributions between 1 nm to 100 nm and between 1 µm to 100 µm. The pore size is determined by mercury porosimetry studies.

Another advantage of the present process is that the conditions of use of the plasma are very simple, because atmospheric plasma is used. Therefore, there is no need to prepare a system in which all the vacuum lines must be checked, the joint must be air tight sealed, *etc...*

The liquid thin film precursor is a liquid metal-organic decomposition (MOD) ink containing the required metal, which is typically oxidised and bound with ligands that can be reduction ligands, coordination ligands and/or auxiliary stabilising ligands. Upon exposure to the atmospheric-pressure plasma, the metal centre is reduced and the ligands decompose cleanly, leaving conductive metal features.

In the example 1, an aqueous silver complex MOD ink, namely [Ag(NH₃)₂]⁺[C₂H₃O₂]⁻, has been selected and has been inkjet-printed onto a porous substrate, namely paper. This inkjet-printing step has been performed with an ultrasonic nozzle, but it could have been performed by any means known by the person skilled in the art to achieve inkjet-printing.

The concentration of the silver complex MOD ink onto the substrate surface is comprised between 10 nL/cm² and 50 nL/cm². Typically, in the described experiment, the concentration was 14 nL/cm². This dilute concentration also facilitates the prevention of any detrimental wetting and absorption on the porous substrates.

At maximum 10 seconds after the inkjet-printing step has been completed, preferentially less than 10 seconds after the end of the inkjet-printing step, the sintering step using plasma is performed. This is also characterized by the use of high processing speed, namely of 10 cm per second. In the described experiment, the plasma sintering step starts 800 µs after the inkjet-printing step. This very short delay between the two steps is of the highest importance in order to prevent the absorption of the liquid MOD ink into the porous substrate, and also in order to prevent the evaporation of the MOD ink components (even though the process is achieved at room temperature). The evaporation of the MOD ink components would cause decomposition of the liquid MOD ink into a brownish coating that cannot be further reduced to the metallic state.

The plasma sintering step is performed using a dielectric barrier discharge (DBD) reactor which generates a plasma typically composed of argon and hydrogen. Other gas can be used, namely nitrogen and/or helium. The ratio of the reducing gas into the plasma composition, namely the ratio of hydrogen in the plasma, amounts to a range comprised between 1 % and 5 %, typically 2.5 %.

The power dissipated in the plasma discharge is low, ranging between 1 W/cm² and 10 W/cm², preferentially about 2 W/cm², and the plasma exposure time is short (between 1 second and 5 seconds per cycle, typically 2 seconds per cycle) which allows for the porous substrate to stay at room temperature at all times.

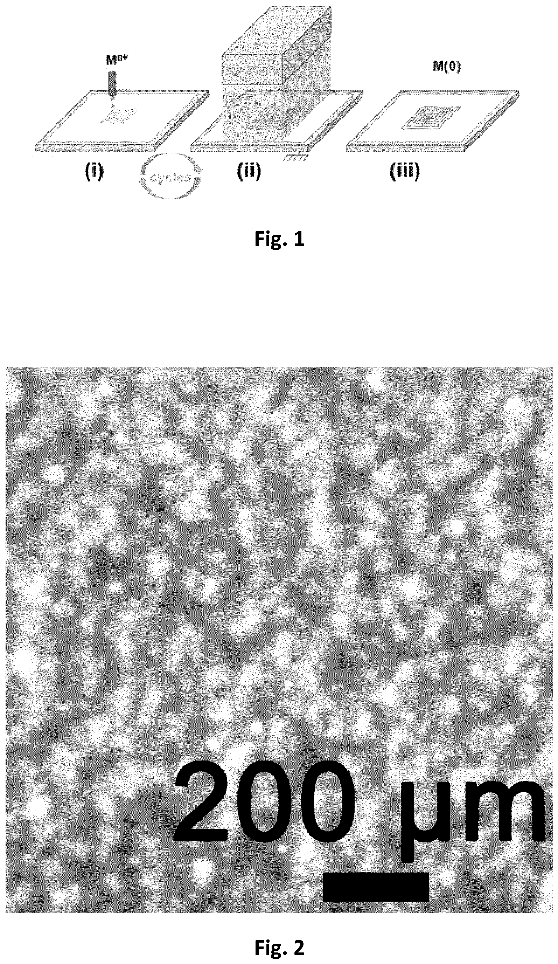

Figure 1 shows a scheme of process of the present invention.

In order to ensure the continuous coverage of the rough porous substrate (Sa = 94 nm in case of paper substrate), the steps of inkjet-printing (step (i) on figure 1) and atmospheric plasma sintering (step (ii) on figure 1) (AP-DBD) may be repeated/cycled several times, typically at least 10 times.

The cycles also allow for increasing of the thickness of the electrically conductive layer, which has for effect to reduce the resistance of the conductive metallic layer. With this system, one can also tune the electrical conductivity of the metallic layer. More particularly, repeating the inkjet-printing and the atmospheric plasma sintering step allows for promoting better connection between the particles composing the metallic layer.

Optical microscopy studies show that the coatings continuously cover the porous substrate (see figure 2).

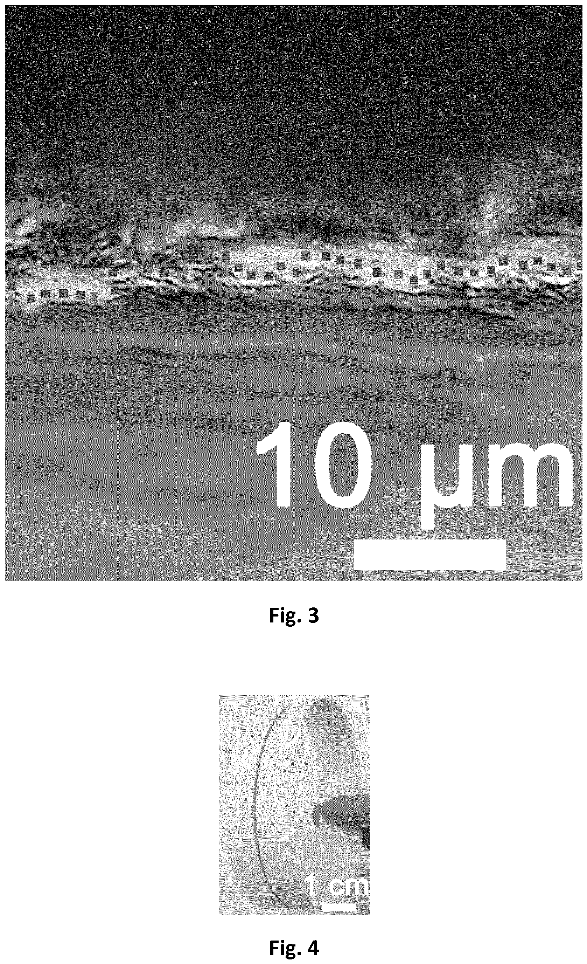

Furthermore, in spite of the porous nature of the (paper) substrate, it has been observed that the MOD ink does not permeate the substrate (see figure 3). Specifically, in figure 4, the backside of the paper on which the experiment has been performed is shown, evidencing that there is no saturation of the paper substrate. As already stated, this is due to the speed of the chemical reduction of the liquid MOD ink to the conductive silver via the plasma.

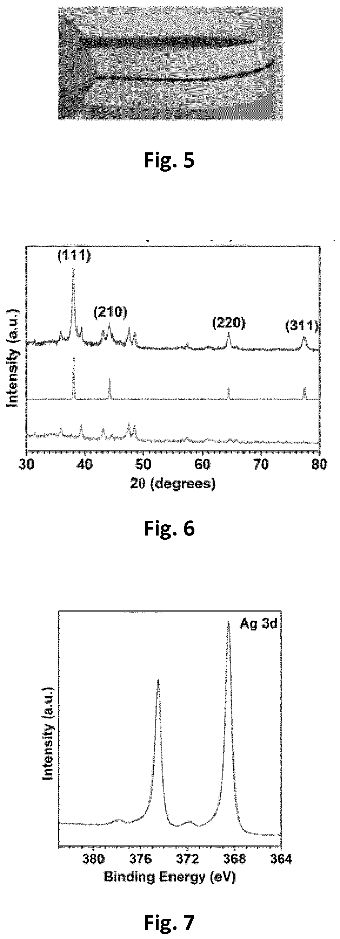

By contrast, if the speed of the chemical reduction is low, for instance 24 hours at room temperature (namely, a thermal sintering step, instead of a plasma sintering step), it leads to the formation of a brownish film (see figure 5) which will not result in a conductive layer.

X-ray diffraction (XRD) analysis of the plasma-assisted inkjet-printed line on paper indicates the formation of metallic silver. Bragg peaks at 38.1°, 44.3°, 64.5° and 77.4° 2θ match the (111), (210), (220) and (311) for silver crystallized in the cubic space group *Fm*3̅*m* (see figure 6). All other features in the pattern were assigned to the paper substrate (see below plot of figure 6, corresponding to XRD pattern of paper substrate).

X-ray photoelectron spectroscopy (XPS) analysis of the plasma-assisted inkjet-printed silver on paper revealed peaks at 368.5 and 374.5 eV corresponding to the 3d_{5/2} and 3d_{3/2} peaks of Ag, respectively (figure 7). The positions of the Ag 3d spin-orbit components, separated by 6 eV, and the presence of loss features at their higher binding energy side is consistent with formation of metallic silver.

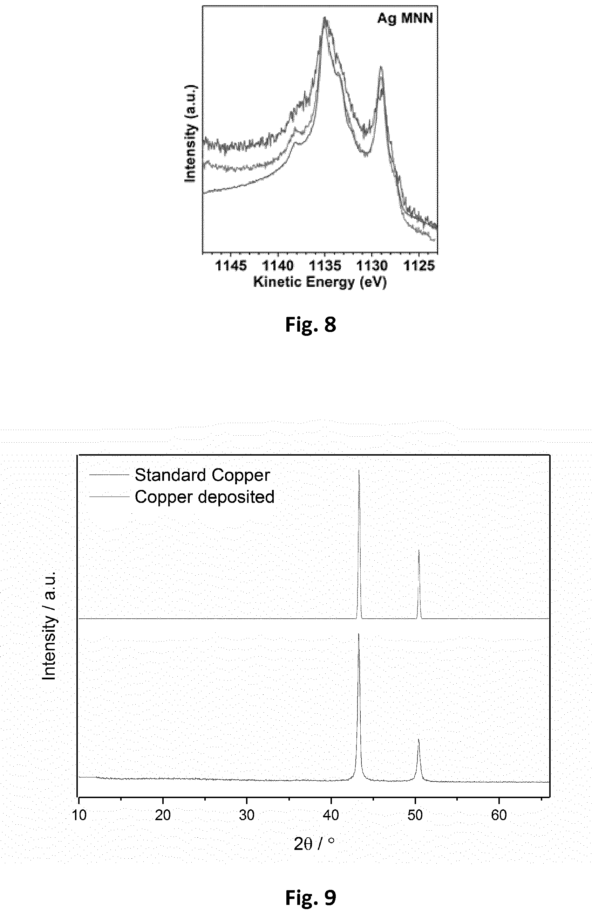

To undoubtedly confirm the oxidation state of the plasma-assisted inkjet-printed silver on paper, the shape of the Ag MNN Auger transition is compared with a pure bulk silver reference on figure 8. To negate the possible issue of charge effects, the Auger parameters have also been calculated. For the plasma-assisted inkjet-printed silver on paper: α (Ag 3d - Ag M₅N_{4,5}N_{4,5}) = 720 eV and α (Ag 3d - Ag M₄N_{4,5}N_{4,5}) = 726.1 eV, consistent with literature values for silver metal, i.e. Ag(0). Furthermore, the Auger parameters calculated for the decomposition of the MOD ink on paper at room temperature (without plasma treatment) are α (Ag 3d - Ag M₅N_{4,5}N_{4,5}) = 719.8 eV and α (Ag 3d - Ag M₄N_{4,5}N_{4,5}) = 725.6 eV, consistent with literature values for silver oxide.

The immediate (only 800 µs after the end of the step of inkjet-printing) plasma sintering of the inkjet-printed silver MOD ink leads to the formation of a silvery metallic coating (with a thickness of about 2 µm) with a conductivity of 3.75 10⁶ S/m on paper.

In conclusion, the plasma-assisted inkjet printing of a silver MOD ink has yielded the formation of highly conductive silver layer on paper. Moving away from thermal sintering, plasma sintering has been shown to be an effective conversion tool to produce conductive metal tracks at roomtemperature and atmospheric-pressure. The proposed approach also considerably shortens the time required for converting MOD inks to metal, overcoming the wetting issues often encountered on porous substrates such as paper.

As a consequence, the developed strategy may aid in the realization of low cost flexible and paper-based electronic devices, including high frequency devices.

A second example describes a paper substrate with a track of copper, obtained through the atmospheric pressure and room temperature process described above.

Copper precursors are of the type [Cu(R')ₓ(R")_{y}]_{z} (where x, y = 0, 1, 2, 3 or 4; z = 1, 2, 3 or 4; R' = NO₃, OOCH; R" = any mono, bi- or tridentate ligand containing C, H, N, O, S, *e.g.* HO(CH₂)ₙNH₂, HO(CH(R'")(CH₂)ₙNH₂, HO(CH₂)ₙ(CH(R"")NH₂ (n = 1 - 50; R'", R"" = any alkyl group, *e.g*. Me, Et, Bu, *etc...* These compounds, isolated in high purity as dark blue crystalline powders, are stable under atmospheric conditions and can be stored indefinitely. Once dispersed into a colloidal suspension, solution or other liquid medium using a suitable organic solvent (e.g. water, methanol, hexane, toluene) they can be coated, printed, sprayed and/or patterned onto paper substrate to be used as precursors to metallic copper.

Precursors of the type [Cu(NO₃)₂(HOCH(R)CH(R')NH₂)₂] (R = R' = H, **1**; R = Me, R' = H, **2**; R = H, R' = Me, **3**), were isolated from the reaction of copper nitrate tetrahydrate ([Cu(NO₃)₂.4(H₂O)], Aldrich) with respective aminoalcohols of the type: HOCH(R)CH(R')NH₂ (R = R' = H, **1**; R = Me, R' = H, **2**; R = H, R' = Me, **3**) (Aldrich, **1**, **3** Alfa Aesar, **2**). Aqueous solutions/inks of **1-3** were inkjet-printed onto paper using a MicroMist ultrasonic nozzle operating at 120 kHz and coupled to an air shaping system from Sono-Tek. The copper ink precursor flow through the ultrasonic nozzle was kept at 1.0 µL/h and the argon gas flow through the air shaping system was set to 0.1 L/min. The paper substrate was moved at 10 cm/s on a stage and quickly placed under a dielectric barrier discharge plasma (Ar/H₂: 19.5/0.5 L/min) for 5 minutes. In the described experiment, the plasma sintering step starts 800 µs after the inkjet-printing step. This very short delay between the two steps is of the highest importance in order to prevent the absorption of the liquid MOD ink into the porous substrate. Cycles were repeated to tune thickness and resistivity of the resultant printed features.

XRD (X-ray diffraction) patterns of all deposits confirm the complete conversion of the copper (II) precursor to metallic copper (figure 9). Since the precursor is crystalline and the pattern collected from 10 - 80° 2θ can only be indexed to pure phase metallic copper, this confirms that no precursor remains on the paper.

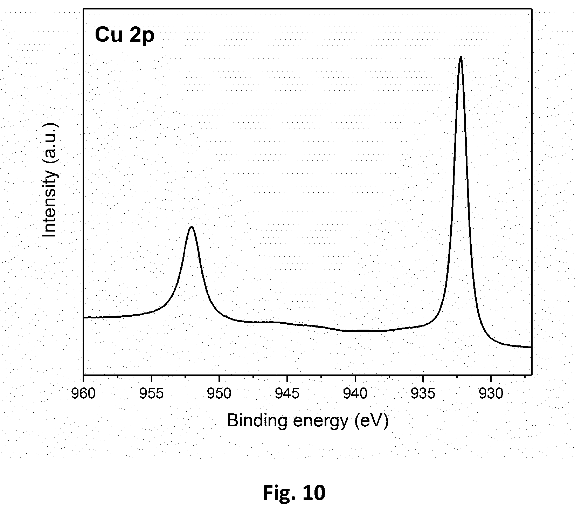

XPS (X-ray photoemission spectroscopy) further evidences the complete conversion of copper precursor to copper metal. The XPS for Cu shows one environment consistent with the presence of Cu(0), the carbon contamination being reported to be lower than 5 wt % (figure 10).

A third example describes a paper and a cellulose substrate with a track of copper, obtained through an atmospheric pressure and room temperature remote plasma discharge process.

Remote discharges are particularly suitable for the treatment of 3D substrates.

As with example 2, copper precursors are of the type [Cu(R')ₓ(R")_{y}]_{z} (where x, y = 0, 1, 2, 3 or 4; z = 1, 2, 3 or 4; R' = NO₃, OOCH; R" = any mono, bi- or tridentate ligand containing C, H, N, O, S, *e.g.* HO(CH₂)ₙNH₂, HO(CH(R'")(CH₂)ₙNH₂, HO(CH₂)ₙ(CH(R"")NH₂ (n = 1 - 50; R'", R"" = any alkyl group, *e.g*. Me, Et, Bu, *etc...* These compounds, isolated in high purity as dark blue crystalline powders, are stable under atmospheric conditions and can be stored indefinitely. Once dispersed into a colloidal suspension, solution or other liquid medium using a suitable organic solvent (e.g. water, methanol, hexane, toluene) they can be coated, printed, sprayed and/or patterned onto paper substrate to be used as precursors to metallic copper.

Precursors can be isolated and then dispersed as described above, but can also be used *in situ,* in which the reagents (*e.g.* copper formate and HO-R-NH₂) (R = any alkyl chain) can be combined and dispersed in a selection of different solvents and used immediately, avoiding chemical workup.

Copper(II) formate tetrahydrate ([Cu(COOH)₂.4(H₂O)], Alfa Aesar) was dissolved in two equivalents of ethanolamine (HOCH₂CH₂NH₂, Aldrich) in a sealed vial. Four equivalents of methanol were then added with stirring. This solution was used to deposit copper, however if left overnight a crystalline precipitate could be isolated, stored and then re-dispersed in methanol and also used to deposit copper.

Highly conductive copper deposits were achieved on glass substrates in atmospheric-pressure remote plasma discharge reactor. In the remote plasma discharge reactor, the discharge is initiated inside the reactor between a minimum of two electrodes where one of the electrodes is the high voltage electrode and the other is ground electrode. The plasma discharge is generated remotely, upstream of the substrate, by means of a plasma torch. In the case of a discharge generated upstream of the substrate, the substrate is exposed to the plasma discharge afterglow or the plasma jet (also called guided streamer).

The copper ink described above was sprayed using an AccuMist ultrasonic nozzle (Sono-Tek) operating at 48 kHz and coupled to an air shaping system set to 5 L/min. The syringe driver supplying the ink was set to 5 µL/min, with a nozzle power of 3 W. The copper ink mist was carried to the substrate through an outlet concomitant but physically separated from the plasma discharge afterglow outlet.

The paper or cellulose substrates were placed 1.5 mm under the outlet of the remote plasma discharge device (N₂: 70 L/min). The plasma sintering step was performed simultaneously to the inkjet-printing step thanks to the concomitant but physically separated MOD ink outlet and plasma discharge afterglow outlet. This absence of delay between the two steps is of the highest importance in order to prevent the absorption of the liquid MOD ink into the porous substrate. Cycles were repeated to tune thickness and resistivity of the resultant deposition. The N₂ plasma power was set to 300 W.

The printing set up was dynamic, in that the precursor ink was coated onto the substrate in small amounts whilst being exposed to the plasma throughout. The torch head was programmed to move back and forth to produce the desired pattern of copper on each substrate.

In one example on paper, a 2 cm line of conductive copper was produced (2 point probe reading of 0.7 Ω), in another on cellulose, a 2 cm line of copper was deposited (2 point probe reading of 2.0 Ω).

Analyses by XRD and XPS further confirm the complete conversion of the precursor into metallic copper (see figures 9 and 10).

## Claims

1. Method for depositing a conductive metal layer on a porous substrate, said method comprising the steps of
a) providing at least one porous substrate,
b) inkjet-printing a liquid metal-organic decomposition ink on said at least one porous substrate, and
c) providing a plasma exposure,
**characterized in that** step (c) is performed less than 10 seconds after the end of step (b).

2. Method according to claim 1, wherein step (c) is performed less than 1 second after the end of step (b).

3. Method according to any one of claims 1-2, wherein step (c) is performed less than 800 µs after the end of step (b).

4. Method according to any one of claims 1-3, wherein said plasma exposure is performed at atmospheric pressure.

5. Method according to any one of claims 1-4, wherein said liquid metal-organic decomposition ink is a liquid metal-organic decomposition silver ink, a liquid metal-organic decomposition copper ink, a liquid metal-organic decomposition aluminium ink, a liquid metal-organic decomposition gold ink, a liquid metal-organic decomposition platinum ink, or a liquid metal-organic decomposition molybdenum ink.

6. Method according to any one of claims 1-5, wherein said porous substrate is a heat-sensitive substrate.

7. Method according to any one of claims 1-6, wherein said porous substrate comprises pores with a size comprised between 1 nm and 100 µm.

8. Method according to any one of claims 1-7, wherein said porous substrate is paper, cardboard, wood, textile, foam or one porous polymer, preferentially paper.

9. Method according to any one of claims 1-8, wherein said porous substrate is flexible.

10. Method according to any one of claims 1-9, wherein step (c) is performed during a time comprised between 1 second and 5 seconds, preferentially during a time of 2 seconds.

11. Method according to any one of claims 1-10, wherein the temperature is comprised between 20°C and 50°C, preferentially between 20°C and 27°C.

12. Method according to any one of claims 1-11, wherein said step (c) is performed by means of a dielectric barrier discharge or by means of a plasma torch.

13. Method according to any one of claims 1-12, wherein said plasma exposure is a plasma discharge with a power comprised between 1 W/cm² and 10 W/cm², preferentially of 2 W/cm⁻².

14. Method according to any one of claims 1-13, wherein said plasma exposure is a plasma discharge comprising nitrogen, argon, helium and/or hydrogen.

15. Method according to any one of claims 1-14, wherein steps (b) and (c) are repeated at least 10 times.

## Patentansprüche

1. Verfahren zum Aufbringen einer leitfähigen Metallschicht auf ein poröses Substrat, wobei das Verfahren die folgenden Schritte umfasst:
a) Bereitstellen mindestens eines porösen Substrats,
b) Tintenstrahldrucken einer flüssigen metallorganischen zersetzungsfähigen Druckfarbe auf das mindestens eine poröse Substrat und
c) Ermöglichen einer Plasmaexposition,
**dadurch gekennzeichnet, dass** Schritt (c) weniger als 10 Sekunden nach dem Ende von Schritt (b) durchgeführt wird.

2. Verfahren nach Anspruch 1, wobei Schritt (c) weniger als 1 Sekunde nach dem Ende von Schritt (b) durchgeführt wird.

3. Verfahren nach einem der Ansprüche 1 bis 2, wobei Schritt (c) weniger als 800 µs Sekunden nach dem Ende von Schritt (b) durchgeführt wird.

4. Verfahren nach einem der Ansprüche 1 bis 3, wobei die Plasmaexposition bei Atmosphärendruck durchgeführt wird.

5. Verfahren nach einem der Ansprüche 1 bis 4, wobei die flüssige metallorganische zersetzungsfähige Druckfarbe eine flüssige metallorganische zersetzungsfähige Silberdruckfarbe, eine flüssige metallorganische zersetzungsfähige Kupferdruckfarbe, eine flüssige metallorganische zersetzungsfähige Aluminiumdruckfarbe, eine flüssige metallorganische zersetzungsfähige Golddruckfarbe, eine flüssige metallorganische zersetzungsfähige Platindruckfarbe oder eine flüssige metallorganische zersetzungsfähige Molybdändruckfarbe ist.

6. Verfahren nach einem der Ansprüche 1 bis 5, wobei das poröse Substrat ein wärmeempfindliches Substrat ist.

7. Verfahren nach einem der Ansprüche 1 bis 6, wobei das poröse Substrat Poren mit einer Größe zwischen 1 nm und 100 µm aufweist.

8. Verfahren nach einem der Ansprüche 1 bis 7, wobei das poröse Substrat Papier, Karton, Holz, Textil, Schaumstoff oder ein poröses Polymer, vorzugsweise Papier ist.

9. Verfahren nach einem der Ansprüche 1 bis 8, wobei das poröse Substrat flexibel ist.

10. Verfahren nach einem der Ansprüche 1 bis 9, wobei Schritt (c) während einer Zeit zwischen 1 Sekunde und 5 Sekunden, vorzugsweise während einer Zeit von 2 Sekunden durchgeführt wird.

11. Verfahren nach einem der Ansprüche 1 bis 10, wobei die Temperatur zwischen 20 °C und 50 °C, vorzugsweise zwischen 20 °C und 27 °C liegt.

12. Verfahren nach einem der Ansprüche 1 bis 11, wobei der Schritt (c) mittels einer stillen elektrischen Entladung oder mittels eines Plasmabrenners durchgeführt wird.

13. Verfahren nach einem der Ansprüche 1 bis 12, wobei die Plasmaexposition eine Plasmaentladung mit einer Leistung zwischen 1 W/cm² und 10 W/cm², vorzugsweise 2 W/cm⁻² ist.

14. Verfahren nach einem der Ansprüche 1 bis 13, wobei die Plasmaexposition eine Plasmaentladung ist, die Stickstoff, Argon, Helium und/oder Wasserstoff umfasst.

15. Verfahren nach einem der Ansprüche 1 bis 14, wobei die Schritte (b) und (c) mindestens 10 mal wiederholt werden.

## Revendications

1. Procédé destiné au dépôt d'une couche métallique conductrice sur un substrat poreux, ledit procédé comprenant les étapes dans lesquelles :
a) on procure au moins un substrat poreux ;
b) on imprime par jet d'encre une encre de décomposition organométallique liquide sur ledit au moins un substrat poreux ; et
c) on procure une exposition à un plasma ;
**caractérisé en ce que** l'étape (c) est mise en œuvre moins de 10 secondes après la fin de l'étape (b).

2. Procédé selon la revendication 1, dans lequel l'étape (c) est mise en œuvre moins de 1 seconde après la fin de l'étape (b).

3. Procédé selon l'une quelconque des revendications 1 à 2, dans lequel l'étape (c) est mise en œuvre moins de 800 µs après la fin de l'étape (b).

4. Procédé selon l'une quelconque des revendications 1 à 3, dans lequel ladite exposition à un plasma est mise en œuvre sous pression atmosphérique.

5. Procédé selon l'une quelconque des revendications 1 à 4, dans lequel ladite encre de décomposition organométallique liquide représente une encre de décomposition organométallique liquide à base d'argent, une encre de décomposition organométallique liquide à base de cuivre, une encre de décomposition organométallique liquide à base d'aluminium, une encre de décomposition organométallique liquide à base d'or, une encre de décomposition organométallique liquide à base de platine ou une encre de décomposition organométallique liquide à base de molybdène.

6. Procédé selon l'une quelconque des revendications 1 à 5, dans lequel ledit substrat poreux représente un substrat sensible à la chaleur.

7. Procédé selon l'une quelconque des revendications 1 à 6, dans lequel ledit substrat poreux comprend des pores dont la dimension est comprise entre 1 nm et 600 µm.

8. Procédé selon l'une quelconque des revendications 1 à 7, dans lequel ledit substrat poreux représente du papier, du carton, du bois, du textile, une mousse ou un polymère poreux, de manière préférentielle du papier.

9. Procédé selon l'une quelconque des revendications 1 à 8, dans lequel ledit substrat poreux est flexible.

10. Procédé selon l'une quelconque des revendications 1 à 9, dans lequel l'étape (c) est mise en œuvre au cours d'un laps de temps qui est compris entre 1 seconde et 5 secondes, de manière préférentielle au cours d'un laps de temps qui s'élève à 2 secondes.

11. Procédé selon l'une quelconque des revendications 1 à 10, dans lequel la température est comprise entre 20 °C et 50 °C, de manière préférentielle entre 20 °C et 27 °C.

12. Procédé selon l'une quelconque des revendications 1 à 11, dans lequel ladite étape (c) est mise en œuvre au moyen d'une décharge à barrière diélectrique ou au moyen d'un pistolet à plasma.

13. Procédé selon l'une quelconque des revendications 1 à 12, dans lequel ladite exposition à un plasma représente une décharge de plasma avec une puissance qui est comprise entre 1 W/cm² et 10 W/cm², de manière préférentielle qui s'élève à 2 W/cm².

14. Procédé selon l'une quelconque des revendications 1 à 13, dans lequel ladite exposition à un plasma représente une décharge de plasma qui comprend de l'azote, de l'argon, de l'hélium et/ou de l'hydrogène.

15. Procédé selon l'une quelconque des revendications 1 à 14, dans lequel les étapes (b) et (c) sont répétées à concurrence d'au moins 10 fois.
